# EUROPEAN PATENT APPLICATION

(11) **EP 4 835 506 A1**
(43) Date of publication of application: **04.11.2026**
(21) Application number: 24910094.2
(22) Date of filing: 29.09.2024
(51) Int. Cl.: G01R 31/396, G01R 31/385, G01R 31/367

(54) **BATTERY CONSISTENCY DETERMINATION METHOD AND RELATED PRODUCT**

(30) Priority: 28.12.2023 CN 202311842059
(71) Applicant: BYD Company Limited, Shenzhen, Guangdong 518118 (CN)
(72) Inventor: DENG, Linwang, Shenzhen, Guangdong 518118 (CN); FENG, Tianyu, Shenzhen, Guangdong 518118 (CN); SHU, Shiwei, Shenzhen, Guangdong 518118 (CN); LI, Zhengkun, Shenzhen, Guangdong 518118 (CN)
(74) Representative: Taor, Simon Edward William
(86) International application number: PCT/CN2024/122265
(87) International publication number: WO 2025/139151

(57) **Abstract**

A method for determining consistency of a battery and a related product. The method for determining the consistency of the battery includes: determining a voltage difference corresponding to each frame of data; determining a battery SOC interval based on a correspondence between the voltage difference corresponding to each frame of data and a battery SOC value in each frame of data, where a voltage difference corresponding to the battery SOC interval is greater than a specified threshold; and determining a difference between an upper limit value of the battery SOC interval and a lower limit value of the battery SOC interval as an SOC deviation of the battery.

## Description

This application claims priority to Chinese Patent Application No. 202311842059.0, filed with the China National Intellectual Property Administration on December 28, 2023 and entitled "METHOD FOR DETERMINING CONSISTENCY OF BATTERY AND RELATED PRODUCT", which is incorporated herein by reference in its entirety.

### TECHNICAL FIELD

This application relates to the field of battery technologies, and in particular, to a method for determining consistency of a battery and a related product.

### BACKGROUND

The rise and popularization of electric vehicles have made a lithium-ion battery pack a core component of a vehicle powertrain system. A lithium iron phosphate battery, due to excellent safety performance, has also become a choice for many battery manufacturers. However, because of an electrochemical property of the lithium iron phosphate battery, a state of charge (state of charge, SOC)-open circuit voltage (open circuit voltage, OCV) curve of the lithium iron phosphate battery exhibits a plateau region. This makes it very difficult to accurately estimate a state of charge of a single cell of the lithium iron phosphate battery, and such property also causes the lithium iron phosphate battery to frequently suffer from consistency problems. To manage and maintain a battery system more effectively, it is necessary to detect cell consistency problems in a timely manner.

Currently, a method for detecting the cell consistency problems mainly focuses on problems caused by cell SOC deviations. An SOC deviation of the battery is usually determined by identifying a voltage inflection point on an SOC-OCV curve and calculating a state of charge difference of each cell when the cell reaches the inflection point. A current manner of calculating the SOC deviation requires calculating a state of charge of each cell when the cell reaches the inflection point. This involves a large computational load.

### SUMMARY

Embodiments of this application provide a method for determining consistency of a battery and a related product, which can reduce a computational load for determining an SOC deviation.

A first aspect of embodiments of this application provides a method for determining consistency of a battery, where the battery includes at least two cells, and the method includes:
determining a voltage difference corresponding to each frame of data, where the voltage difference is a difference between a maximum cell voltage and a minimum cell voltage in each frame of data;
determining a battery SOC interval based on a correspondence between the voltage difference corresponding to each frame of data and a battery SOC value in each frame of data, where a voltage difference corresponding to the battery SOC interval is greater than a specified threshold; and
determining a difference between an upper limit value of the battery SOC interval and a lower limit value of the battery SOC interval as an SOC deviation of the battery, where the SOC deviation of the battery is used to measure consistency of the battery.

Optionally, each frame of data is any preprocessed frame of data of the battery within a specified time period.

Optionally, the specified time period includes at least one of a discharging period, an alternating current charging period, or a direct current charging period.

Optionally, the preprocessing includes at least one of: sorting by time, removing a null value, removing duplicate data, removing an invalid value, removing a sampling outlier, or removing data that does not meet an operating condition of an algorithm.

Optionally, after the determining a voltage difference corresponding to each frame of data, the method further includes:
performing filtering processing on the voltage difference corresponding to each frame of data to obtain a processed voltage difference corresponding to each frame of data; and
the determining a battery SOC interval based on a correspondence between the voltage difference corresponding to each frame of data and a battery SOC value in each frame of data, where a voltage difference corresponding to the battery SOC interval is greater than a specified threshold includes:
   determining the battery SOC interval based on a correspondence between the processed voltage difference corresponding to each frame of data and the battery SOC value in each frame of data, where a processed voltage difference corresponding to the battery SOC interval is greater than a specified threshold.

Optionally, the performing filtering processing on the voltage difference corresponding to each frame of data to obtain a processed voltage difference corresponding to each frame of data includes:
determining a credible voltage difference set from the voltage difference corresponding to each frame of data within the specified time period;
performing polynomial fitting based on the credible voltage difference set to obtain a fitted voltage difference corresponding to each frame of data within the specified time period; and
performing filtering processing on the fitted voltage difference corresponding to each frame of data within the specified time period to obtain the processed voltage difference corresponding to each frame of data.

Optionally, the determining a credible voltage difference set from the voltage difference corresponding to each frame of data within the specified time period includes:
obtaining, based on a correspondence between the voltage difference corresponding to each frame of data and a sampling time point corresponding to each frame of data, a first curve of the voltage difference corresponding to each frame of data within the specified time period varying with time; and
determining a first curve segment in the first curve in which the voltage difference is greater than a first threshold, determining a lower envelope region in the first curve segment, and determining N smallest voltage differences in the lower envelope region as the credible voltage difference set from the voltage difference corresponding to each frame of data within the specified time period, where N is an integer greater than or equal to 2.

Optionally, the determining the battery SOC interval based on a correspondence between the processed voltage difference corresponding to each frame of data and the battery SOC value in each frame of data includes:
obtaining, based on the correspondence between the processed voltage difference corresponding to each frame of data and the battery SOC value in each frame of data, a second curve of the processed voltage difference within the specified time period varying with the battery SOC value; and
determining a second curve segment in the second curve in which the processed voltage difference is greater than the specified threshold, and determining a battery SOC interval corresponding to the second curve segment.

Optionally, the obtaining, based on the correspondence between the processed voltage difference corresponding to each frame of data and the battery SOC value in each frame of data, a second curve of the processed voltage difference within the specified time period varying with the battery SOC value includes:
determining, based on the correspondence between the processed voltage difference corresponding to each frame of data and the battery SOC value in each frame of data, a smallest value in at least two processed voltage differences corresponding to a same battery SOC value as the processed voltage difference corresponding to the same battery SOC value; and
obtaining, based on a processed voltage difference corresponding to each different battery SOC value, the second curve of the processed voltage difference within the specified time period varying with the battery SOC value.

Optionally, after the obtaining the SOC deviation of the battery, the method further includes:
uploading the SOC deviation of the battery to a cloud server.

Optionally, the specified threshold is greater than a difference between an upper limit value of a voltage fluctuation range of a first plateau region and a lower limit value of the voltage fluctuation range of the first plateau region, the specified threshold is greater than a difference between an upper limit value of a voltage fluctuation range of a second plateau region and a lower limit value of the voltage fluctuation range of the second plateau region, the specified threshold is less than an absolute value of a difference between the upper limit value of the voltage fluctuation range of the first plateau region and the lower limit value of the voltage fluctuation range of the second plateau region, and the first plateau region and the second plateau region are two adjacent plateau regions in an SOC-OCV curve of the battery.

Optionally, the SOC-OCV curve of the battery includes a small plateau region, a first large plateau region, and a second large plateau region, and an SOC value of the first large plateau region is greater than an SOC value of the small plateau region and less than an SOC value of the second large plateau region; and the first plateau region is one of the first large plateau region and the second large plateau region, and the second plateau region is the other of the first large plateau region and the second large plateau region.

A second aspect of embodiments of this application provides an apparatus for determining consistency of a battery, where the battery includes at least two cells, and the apparatus includes:
a determining unit, configured to determine a voltage difference corresponding to each frame of data, where the voltage difference is a difference between a maximum cell voltage and a minimum cell voltage in each frame of data, where
the determining unit is further configured to determine a battery SOC interval based on a correspondence between the voltage difference corresponding to each frame of data and a battery SOC in each frame of data, where a voltage difference corresponding to the battery SOC interval is greater than a specified threshold; and
the determining unit is further configured to determine a difference between an upper limit value and a lower limit value of the battery SOC interval as an SOC deviation of the battery, where the SOC deviation of the battery is used to measure consistency of the battery.

A third aspect of embodiments of this application provides a server, the server includes a first communication module and a processing module, the first communication module is configured to communicate with an electric energy device in which a battery is located to receive each frame of data, and the processing module is configured to perform the steps according to the first aspect of embodiments of this application.

Optionally, when the SOC deviation is greater than a preset warning threshold, the processing module is further configured to send a warning signal to the electric energy device through the first communication module.

A fourth aspect of embodiments of this application provides an electric energy device, the electric energy device includes a battery and a second communication module, and the second communication module is configured to send each frame of data of the battery to a server, to enable the server to perform the steps according to the first aspect of embodiments of this application based on each frame of data.

A fifth aspect of embodiments of this application provides an electric energy device, the electric energy device includes a battery and a processing component, the processing component is configured to perform the steps according to the first aspect of embodiments of this application based on each frame of data of the battery.

Optionally, the electric energy device includes a warning component, and the processing component is further configured to: when the SOC deviation is greater than a preset warning threshold, trigger the warning component to issue warning information and/or transmit warning prompt information to a third-party device.

A sixth aspect of embodiments of this application provides an electronic device, including a processor and a memory, the memory is configured to store a computer program, the computer program includes program instructions, and the processor is configured to invoke the program instructions to perform the steps according to the first aspect of embodiments of this application.

A seventh aspect of embodiments of this application provides a computer-readable storage medium, where the foregoing computer-readable storage medium stores a computer program for electronic data exchange, and the foregoing computer program enables a computer to perform some or all of the steps according to the first aspect of embodiments of this application.

An eighth aspect of embodiments of this application provides a computer program product, the foregoing computer program product includes a computer program, and the foregoing computer program is operable to enable a computer to perform some or all of the steps according to the first aspect of embodiments of this application. The computer program product may be a software installation package.

A ninth aspect of embodiments of this application provides a processor, the processor is configured to invoke program instructions to perform the steps according to the first aspect of embodiments of this application. The processor may include any one of a chip, an integrated circuit, a micro control unit (micro control unit, MCU), or a computer terminal.

In embodiments of this application, a voltage difference corresponding to each frame of data is determined, where the voltage difference is a difference between a maximum cell voltage and a minimum cell voltage in each frame of data; a battery SOC interval is determined based on a correspondence between the voltage difference corresponding to each frame of data and the battery SOC value in each frame of data, where a voltage difference corresponding to the battery SOC interval is greater than a specified threshold; and a difference between an upper limit value of the battery SOC interval and a lower limit value of the battery SOC interval is determined as an SOC deviation of a battery, where the SOC deviation of the battery is used to measure consistency of the battery. In embodiments of this application, the battery SOC interval is determined based on the correspondence between the voltage difference corresponding to each frame of data and the battery SOC value in each frame of data, and the difference between the upper limit value of the battery SOC interval and the lower limit value of the battery SOC interval is determined as the SOC deviation of the battery. In a process of determining the SOC deviation of the battery, only the battery SOC value needs to be used, and there is no need to calculate an SOC value of each cell. This can reduce a computational load for determining the SOC deviation, thereby quickly determining consistency of the battery.

### BRIEF DESCRIPTION OF DRAWINGS

To describe the technical solutions in embodiments of this application or the conventional technology more clearly, the following briefly describes the accompanying drawings required for describing the embodiments or the conventional technology. Clearly, the accompanying drawings in the following description show merely some embodiments of this application, and a person of ordinary skill in the art may still derive other drawings from these accompanying drawings without creative efforts.
FIG. 1 is a schematic diagram of an SOC-OCV curve of a lithium iron phosphate battery according to an embodiment of this application;
FIG. 2 is a schematic flowchart of a method for determining consistency of a battery according to an embodiment of this application;
FIG. 3 is a schematic diagram of a correspondence between a voltage difference corresponding to each frame of data and a battery SOC value in each frame of data according to an embodiment of this application;
FIG. 4 is a schematic flowchart of another method for determining consistency of a battery according to an embodiment of this application;
FIG. 5 is a schematic diagram of a first curve of a voltage difference varying with time according to an embodiment of this application;
FIG. 6 is a schematic diagram of a second curve of a voltage difference varying with a battery SOC value according to an embodiment of this application;
FIG. 7 is a specific schematic flowchart of a method for determining consistency of a battery according to an embodiment of this application;
FIG. 8 is a schematic diagram of a structure of an apparatus for determining consistency of a battery according to an embodiment of this application;
FIG. 9 is a schematic diagram of a structure of an electronic device according to an embodiment of this application;
FIG. 10 is a schematic diagram of a structure of a server according to an embodiment of this application;
FIG. 11 is a schematic diagram of a structure of an electric energy device according to an embodiment of this application; and
FIG. 12 is a schematic diagram of a structure of an electric energy device according to an embodiment of this application.

### DESCRIPTION OF EMBODIMENTS

The technical solutions in embodiments of this application are clearly and completely described below with reference to the accompanying drawings in embodiments of this application. Obviously, the described embodiments are merely some, rather than all, of embodiments of this application. All other embodiments obtained by a person of ordinary skill in the art based on embodiments of this application without creative efforts shall fall within the protection scope of this application.

The terms "first", "second", and the like in the specification, claims, and accompanying drawings of this application are used to distinguish between different objects, and are not used to describe a specific sequence. In addition, terms "include" and "have" and any variations thereof are intended to cover non-exclusive inclusion. For example, a process, a method, a system, a product, or a device that includes a series of steps or units is not limited to listed steps or units, but optionally further includes steps or units that are not listed, or optionally further includes other steps or units inherent to the process, the method, the product, or the device.

In the context of this application, reference to "an embodiment" means that a particular feature, structure, or characteristic described with reference to the embodiment may be included in at least one embodiment of this application. The appearance of this phrase in various places in the specification does not necessarily refer to a same embodiment, nor is it an independent or alternative embodiment that is mutually exclusive with other embodiments. A person skilled in the art explicitly and implicitly understands that embodiments described in this application may be combined with other embodiments.

In an electric vehicle, to accurately obtain an SOC of a cell, a state of charge (state of charge, SOC)-open circuit voltage (open circuit voltage, OCV) curve is usually used. By sampling an open circuit voltage of the cell, the SOC of the cell may be obtained based on an OCV-SOC mapping relationship in the SOC-OCV curve. The SOC-OCV curve may also be referred to as an OCV curve for short.

Because of an electrochemical property of a lithium iron phosphate (whose chemical formula is LiFePO4, LFP for short) battery, the SOC-OCV curve of the lithium iron phosphate battery exhibits a plateau region. This makes it very difficult to accurately estimate a state of charge of a single cell, and such property also causes the lithium iron phosphate battery to frequently suffer from consistency problems. To manage and maintain a battery system more effectively, it is necessary to detect cell consistency problems in a timely manner. Currently, a method for detecting the cell consistency problems mainly focuses on problems caused by cell SOC deviations. An SOC deviation of the battery is usually determined by identifying a voltage inflection point on an SOC-OCV curve and calculating a state of charge difference of each cell when the cell reaches the inflection point. A current manner of calculating the SOC deviation requires calculating a state of charge of each cell when the cell reaches the inflection point. This involves a large computational load.

In an SOC deviation calculation method in embodiments of this application, a battery SOC interval is determined based on a correspondence between a voltage difference corresponding to each frame of data and a battery SOC value in each frame of data, and a difference between an upper limit value of the battery SOC interval and a lower limit value of the battery SOC interval is determined as the SOC deviation of the battery. Only the battery SOC value needs to be used, and there is no need to calculate the SOC value of each cell. This can reduce a computational load for determining the SOC deviation, thereby quickly determining consistency of the battery.

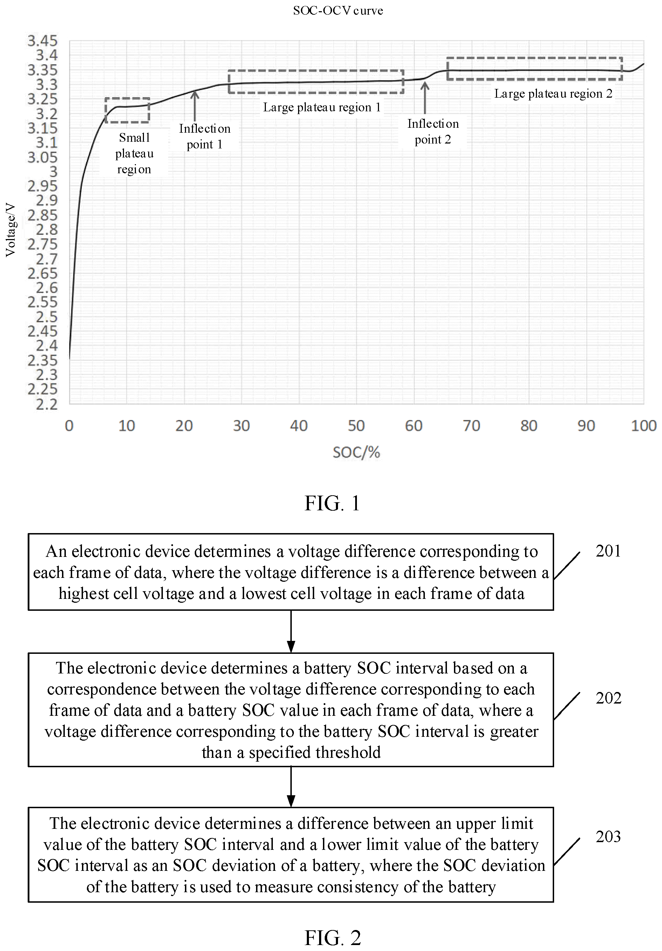

Refer to FIG. 1. FIG. 1 is a schematic diagram of an SOC-OCV curve of a lithium iron phosphate battery according to an embodiment of this application. As shown in FIG. 1, a horizontal axis represents an SOC value, and a vertical axis represents an open circuit voltage (OCV) value. It can be seen from FIG. 1 that after an open circuit voltage of a cell is obtained, a corresponding SOC value can be obtained based on the SOC-OCV curve.

From the SOC-OCV curve of the lithium iron phosphate LFP in FIG. 1, it can be learned that the SOC-OCV curve of the lithium iron phosphate battery is nonlinear, and exhibits a small plateau region and two large plateau regions. If a cell with a maximum state of charge (that is, state of charge) and a cell with a minimum state of charge are both within a same plateau region, a voltage difference calculated from a voltage of the cell with the maximum state of charge and a voltage of the cell with the minimum state of charge is very small. As an electric device discharges or charges, the cell with the maximum state of charge and the cell with the minimum state of charge successively pass an inflection point (for example, an inflection point 2 in FIG. 1) of the two large plateau regions (for example, a large plateau region 1 and a large plateau region 2 shown in FIG. 1). A consistency difference between cells can be calculated by calculating a change in a battery SOC in a state in which the cell with the maximum state of charge is in a high-voltage plateau and the cell with the minimum state of charge is in a low-voltage plateau. FIG. 1 includes two inflection points: an inflection point 1 and the inflection point 2. The inflection point 1 is an inflection point with a lower state of charge, and the inflection point 2 is an inflection point with a higher state of charge.

The electric device may be any device powered by electrical energy. For example, the electric device may include any one of a vehicle, an aircraft, a vessel, or an energy storage cabinet.

It should be noted that FIG. 1 is merely a possible example of the SOC-OCV curve. In the SOC-OCV curve, the OCV may alternatively be used as the horizontal axis, and the SOC value may alternatively be used as the vertical axis.

Refer to FIG. 2. FIG. 2 is a schematic flowchart of a method for determining consistency of a battery according to an embodiment of this application. As shown in FIG. 2, the method for determining consistency of a battery includes the following steps.

201: An electronic device determines a voltage difference corresponding to each frame of data, where the voltage difference is a difference between a maximum cell voltage and a minimum cell voltage in each frame of data.

The electronic device may be any device with computing and communication capabilities. For example, the electronic device may be a cloud server. The electronic device may be a cloud server used to calculate an SOC deviation of a battery.

In this embodiment of this application, the voltage difference is equal to the maximum cell voltage in each frame of data minus the minimum cell voltage.

Each frame of data refers to state data of the battery that is sampled in each sampling periodicity. The battery may include at least two cells, and the state data of the battery may include: voltages of the at least two cells, section numbers of the at least two cells, a battery SOC, and the like. For example, if the sampling periodicity is 30 seconds, each frame of data includes data of the battery, for example, voltages of the at least two cells, section numbers of the at least two cells, a battery SOC, and the like, that are sampled within 30 seconds. A frame of data may exist in a form of a data frame, or may exist in any other form capable of carrying the state data of the battery, for example, a data sequence. This is not limited in embodiments of this application.

Each frame of data may include the maximum cell voltage, the minimum cell voltage, and the battery SOC. The battery may be formed by connecting at least two cells in series. The maximum cell voltage in each frame of data refers to a voltage of a cell with a maximum sampled cell voltage among all cells of the battery within the sampling periodicity (for example, the sampling period may be 30 seconds) of each frame of data. The minimum cell voltage in each frame of data refers to a voltage of a cell with a minimum sampled cell voltage among all cells of the battery within the sampling periodicity of each frame of data.

For example, the battery may include 120 cells. Each frame of data may include a voltage of a cell with a maximum sampled voltage (the maximum cell voltage) among the 120 cells, a voltage of a cell with a minimum sampled voltage (the minimum cell voltage), and the battery SOC within the sampling periodicity corresponding to the frame of data.

It should be noted that the battery SOC is different from a cell SOC. The battery SOC refers to an SOC of the entire battery, and the cell SOC refers to an SOC of the cell.

Each frame of data may further include a section number of a cell with a maximum voltage and a section number of a cell with a minimum voltage among the plurality of cells.

Optionally, each frame of data is any preprocessed frame of data of the battery within a specified time period.

In this embodiment of this application, each frame of data in step 201 is a preprocessed frame of data.

The electronic device may obtain all original frames of data uploaded by a same vehicle within the specified time period, and process each original frame of data uploaded by the same vehicle within the specified time period to obtain each frame of data in step 201.

For example, the specified time period is 72 hours. The same vehicle may periodically sample original state data of a battery of the vehicle in a specified sampling periodicity and report the original state data of the battery to the electronic device in the form of an original frame of data. The specified sampling periodicity may be specified in advance, and the specified sampling periodicity may be set to any value within 1 to 100 seconds. For example, the specified sampling periodicity may be set to 30 seconds. In this case, within a 72-hour specified time period, a total of 8640 (72×60×2) original frames of data reported by the same vehicle may be received. The original state data of the battery may include data of the battery, for example, original voltages of the at least two cells, original section numbers of the at least two cells, an original battery SOC, and the like.

Optionally, the specified time period includes at least one of a discharging period, an alternating current charging period, or a direct current charging period.

Optionally, the specified time period includes at least one of a discharging period or an alternating current charging period.

In embodiments of this application, the SOC deviation of the battery may be calculated based on frames of data reported by the battery in the discharging period, or the SOC deviation of the battery may be calculated based on frames of data reported by the battery in the alternating current charging phase, or the SOC deviation of the battery may be calculated based on frames of data reported by the battery in the discharging period and the alternating current charging phase. The method for determining consistency of a battery in embodiments of this application may be applied to a discharging operating condition, and may further be applied to an alternating current charging operating condition.

Embodiments of this application may be applied to inflection point prediction and SOC deviation calculation during the discharging period or the alternating current charging period. Every vehicle has a discharging period, so a sufficient quantity of frames of data is ensured. In the method for determining consistency of a battery in embodiments of this application, SOC deviations of all vehicles may be accurately calculated.

Herein, the specified time period may include data when the battery SOC is within a specified SOC value interval in the discharging period and the alternating current charging period. The specified SOC value interval may be specified in advance. The specified SOC value interval may include, in FIG. 1, a part of the large plateau region 1, a part of the large plateau region 2, and the inflection point 2 between the large plateau region 1 and the large plateau region 2. For example, the specified SOC value interval may be 50% to 90%. On one hand, within the specified SOC value interval, data frequently appears, thereby providing sufficient data to calculate the SOC deviation, and allowing the electronic device to quickly obtain a calculation result of the SOC deviation. On the other hand, within the specified SOC value interval, there is only one frequently occurring inflection point (for example, the inflection point 2 shown in FIG. 1), so that calculating of the SOC deviation is not interfered with by another inflection point (for example, the inflection point 1 shown in FIG. 1). Moreover, compared to a small plateau region of data near the inflection point 1 which persists for relatively short duration, the specified SOC value interval is near the inflection point 2, where the large plateau region 1 and the large plateau region 2 have relatively long duration. Therefore, within the specified SOC value interval, there is a larger amount of data, and credibility of the data is higher, so that accuracy of the SOC deviation calculated based on the data within the specified SOC value interval is higher. In this way, the SOC deviation can be calculated quickly and accurately.

When the battery is charged, once the cell with the maximum voltage is fully charged, all cells (including the cell with the minimum voltage) are no longer charged. Therefore, an SOC of the cell with the minimum voltage at this time may be above 90% but does not reach 100%. Data above 90% at this time is unreliable. There may be a large voltage difference.

In addition, 50% to 90% is frequently occurring data. In an actual charging and discharging operating condition, a probability of encountering the inflection point 1 in FIG. 1 is lower than that of encountering the inflection point 2. Therefore, a segment of data that includes the inflection point 2 with the high probability is selected.

Optionally, the preprocessing includes at least one of: sorting by time, removing a null value, removing duplicate data, removing an invalid value, removing a sampling outlier, or removing data that does not meet an operating condition of an algorithm.

Sorting by time: Each original data frame uploaded by the same vehicle includes a sampling time point of the original data frame. Sorting may be performed chronologically based on the sampling time point of each original data frame.

Removing a null value: There may be no data in some fields in the original data frame. For example, if a value of a field corresponding to the battery SOC is "None" or "null", it indicates that there is a null value in the original data frame. The original data frame with the null value may be removed.

Removing duplicate data: If same data appears two or more times within the original data frame, the duplicated data is removed, and only one piece of data is kept.

Removing an invalid value: The invalid value is data that is clearly contradictory to the fact. For example, the maximum cell voltage is 2.4 V, while the minimum cell voltage is 3.2 V. Such original data frame with the invalid value may be removed.

Removing a sampling outlier: The sampling outlier is a value outside a range corresponding to a parameter. For example, a range for the SOC value is 0 to 100%. If the SOC value in the reported original data frame is -10, the value is a sampling outlier. The original data frame with the sampling outlier may be removed.

Removing data that does not meet an operating condition of an algorithm: For example, the method for determining consistency of a battery in embodiments of this application is not applicable to the direct current charging period. In this case, data from in the direct current charging period may be removed.

In embodiments of this application, the original data frame may be preprocessed to obtain the frame of data.

202: The electronic device determines a battery SOC interval based on a correspondence between the voltage difference corresponding to each frame of data and a battery SOC value in each frame of data, where a voltage difference corresponding to the battery SOC interval is greater than a specified threshold.

In embodiments of this application, each frame of data includes a battery SOC value, and each frame of data corresponds to a voltage difference. The correspondence between the voltage difference corresponding to each frame of data and the battery SOC value in each frame of data may be established based on the voltage difference corresponding to each frame of data and the battery SOC value in each frame of data. The correspondence may include a relationship pair set. The relationship pair set includes a plurality of relationship pairs, and each relationship pair includes a voltage difference and a corresponding battery SOC value. The relationship pair set may be stored in a memory (for example, a non-volatile memory) of the electronic device. From the relationship pair set, a target relationship pair set in which the voltage difference is greater than the specified threshold may be determined. An interval of SOC values in the target relationship pair set is determined, that is, the battery SOC interval.

For example, within a specified time period, there are 10,000 frames of data. Based on a voltage difference corresponding to each frame of data and the battery SOC value in each frame of data among the 10,000 frames of data, the correspondence between the voltage difference corresponding to each frame of data and the battery SOC value in each frame of data may be established. For example, voltage differences corresponding to different battery SOC values within a range of battery SOC values between 50% and 90% may be obtained, to determine the SOC interval corresponding to the voltage difference greater than the specified threshold.

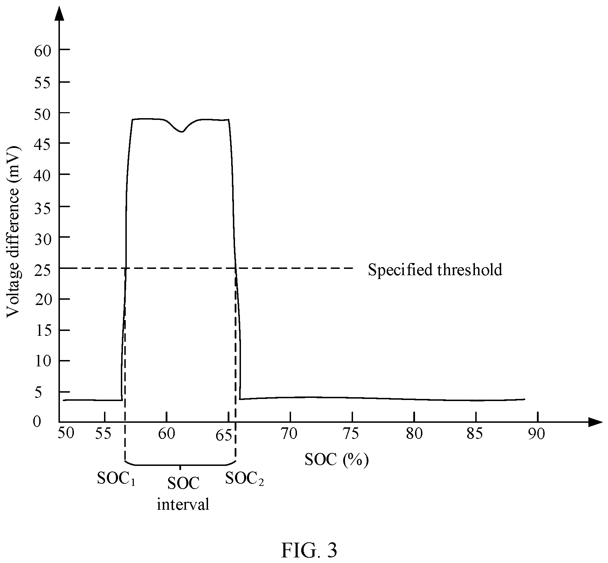

Refer to FIG. 3. FIG. 3 is a schematic diagram of a correspondence between a voltage difference corresponding to each frame of data and a battery SOC value in each frame of data according to an embodiment of this application. As shown in FIG. 3, a horizontal axis represents a battery SOC value, and a vertical axis represents a voltage difference. The SOC interval corresponding to the voltage difference greater than the specified threshold may be determined. As shown in FIG. 3, a lower limit value of the SOC interval is SOC₁, and an upper limit value of the SOC interval is SOC₂.

203: The electronic device determines a difference between the upper limit value of the battery SOC interval and the lower limit value of the battery SOC interval as the SOC deviation of the battery, where the SOC deviation of the battery is used to measure consistency of the battery.

In this embodiment of this application, the lower limit value of the SOC interval may be understood as a battery SOC value (for example, may be denoted as SOC₁) when the cell with the maximum voltage in the battery passes through an inflection point (for example, the inflection point 2 in FIG. 1). The upper limit value of the SOC interval may be understood as a battery SOC value (for example, may be denoted as SOC₂) when the cell with the minimum voltage in the battery passes through the inflection point (for example, the inflection point 2 in FIG. 1). The SOC deviation of the battery may be obtained by subtracting SOC₁ from SOC₂.

In embodiments of this application, an absolute value of the difference between the upper limit value of the battery SOC interval and the lower limit value of the battery SOC interval may be used as the SOC deviation of the battery.

The SOC deviation of the battery is used to measure the consistency of the battery, and the SOC deviation of the battery is an important criterion for evaluating the consistency of the battery. Generally, a smaller SOC deviation of the battery indicates better consistency of the battery, and a larger SOC deviation of the battery indicates worse consistency of the battery.

In embodiments of this application, the battery SOC interval is determined based on the correspondence between the voltage difference corresponding to each frame of data and the battery SOC value in each frame of data, and the difference between the upper limit value of the battery SOC interval and the lower limit value of the battery SOC interval is determined as the SOC deviation of the battery. In a process of determining the SOC deviation of the battery, only the battery SOC value needs to be used, and there is no need to calculate an SOC value of each cell. This can reduce a computational load for determining the SOC deviation, thereby quickly determining consistency of the battery.

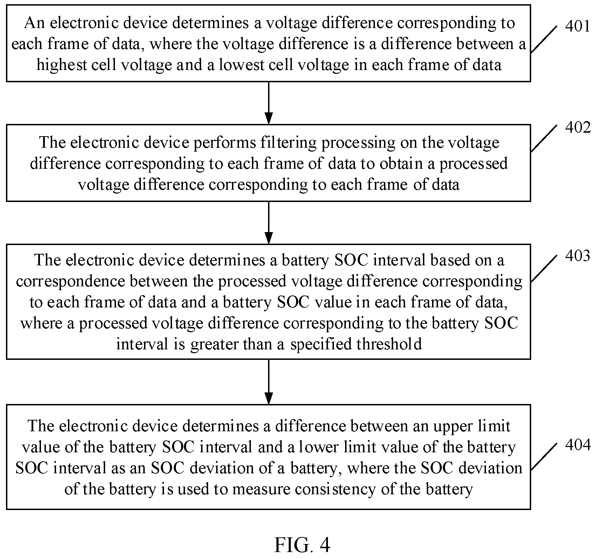

Refer to FIG. 4. FIG. 4 is a schematic flowchart of another method for determining consistency of a battery according to an embodiment of this application. As shown in FIG. 4, the method for determining consistency of a battery includes the following steps.

401: An electronic device determines a voltage difference corresponding to each frame of data, where the voltage difference is a difference between a maximum cell voltage and a minimum cell voltage in each frame of data.

402: The electronic device performs filtering processing on the voltage difference corresponding to each frame of data to obtain a processed voltage difference corresponding to each frame of data.

In embodiments of this application, since the maximum cell voltage and the minimum cell voltage in each frame of data are sampled within the same sampling periodicity, there may be a difference in a voltage sampling time point of each cell within the sampling periodicity (for example, the sampling periodicity may be set to 30 seconds). If the battery discharges rapidly (for example, during uphill climbing of an electric vehicle) or charges rapidly (for example, during emergency braking of the electric vehicle) within the sampling periodicity, and the difference in the voltage sampling time point of the cell is large (a maximum difference is 30 seconds if the sampling periodicity is 30 seconds), there is a deviation between the voltage difference between the maximum cell voltage and the minimum cell voltage in each frame of data and a true voltage difference.

In embodiments of this application, filtering processing may be performed on the voltage difference corresponding to each frame of data to obtain the processed voltage difference corresponding to each frame. In this way, the processed voltage difference corresponding to each frame of data is closer to the true voltage difference, thereby improving calculation accuracy of the SOC deviation.

Optionally, step 402 may specifically include the following steps.

(11) The electronic device determines a credible voltage difference set from the voltage difference corresponding to each frame of data within the specified time period.

(12) The electronic device performs polynomial fitting based on the credible voltage difference set to obtain a fitted voltage difference corresponding to each frame of data within the specified time period.

(13) The electronic device performs filtering processing on the fitted voltage difference corresponding to each frame of data within the specified time period to obtain the processed voltage difference corresponding to each frame of data.

In embodiments of this application, the electronic device may determine the credible voltage difference set from the voltage difference corresponding to each frame of data within the specified time period. Since a sampling time point of each cell may vary, there is a deviation between the voltage difference between the maximum cell voltage and the minimum cell voltage in each frame of data and the true voltage difference. The credible voltage difference set may be found from the voltage difference corresponding to each frame of data within the specified time period. Polynomial fitting may be performed based on the credible voltage difference set to obtain the fitted voltage difference corresponding to each frame of data within the specified time period. Filtering processing is performed on the fitted voltage difference corresponding to each frame of data within the specified time period, to obtain the processed voltage difference corresponding to each frame of data.

For example, within a specific sampling periodicity, for example, a cell 1 and a cell 2 are the cell with the maximum voltage and the cell with the minimum voltage, respectively. The voltages of the two cells may not be sampled at a same moment. At an inflection point, a smallest value theory exists, that is, if a sampling time point of the cell with the maximum voltage and the sampling time point of the cell with the minimum voltage are not the same, there is a very high probability that a voltage difference calculated based on the voltage of the cell with the maximum voltage and the voltage of the cell with the minimum voltage is greater than a true voltage difference. Based on the smallest value theory, in embodiments of this application, smaller voltage differences located in an inflection point region are selected, as the credible voltage difference set, from voltage differences corresponding to each frame of data within the specified time period, thereby increasing credibility of the credible voltage difference set.

Regarding the smallest value theory, an example may be used for description. Refer to Table 1. Table 1 is a table of true voltage differences and voltage differences calculated through sampling for three cells according to an embodiment of this application.

**Table 1**

| Cell number | True value | Sampled value 1 (first sampling time point) | Sampled value 2 (second sampling time point) | Sampled value 3 (third sampling time point) | True voltage difference | Voltage difference calculated through sampling |
|---|---|---|---|---|---|---|
| 1 | 50 | 49 | 50 | 51 | 2 | There are a total of 27 combinations. In the 27 combinations, there is 1 combination in which the difference is 0, 6 combinations in which the difference is 1, 9 combinations in which the difference is 2, 8 combinations in which the difference is 3, and 3 combinations in which the difference is 4. |
| 2 | 51 | 50 | 51 | 52 | | |
| 3 | 52 | 51 | 52 | 33 | | |

The voltage difference calculated through sampling is the difference obtained by subtracting a voltage of a cell with a minimum voltage from a voltage of a cell with a maximum voltage in the three cells. The first sampling time point, the second sampling time point, and the third sampling time point are three possible sampling time points within the sampling periodicity, and the three sampling time points are different. As shown in Table 1, a probability of being less than 2 is 7/27, which is relatively small, and a probability of being greater than 2 is 11/27, which is relatively large. A probability that the voltage difference calculated through sampling is greater than the true voltage difference is higher than a probability that the voltage difference calculated through sampling is less than the true voltage difference. Table 1 is merely an example. In an actual battery product, a quantity of cells in a battery is far greater than 3, making the probability that the voltage difference calculated through sampling is greater than the true voltage difference much higher than the probability that the voltage difference calculated through sampling is less than the true voltage difference.

The electronic device may perform polynomial fitting based on the credible voltage difference set to obtain the fitted voltage difference corresponding to each frame of data within the specified time period. In the credible voltage difference set, each credible voltage difference corresponds to one frame of data. Each frame of data carries one sampling time point to indicate a sampling time point of the frame of data. The sampling time point of the frame of data may be a time point within a sampling periodicity of the frame of data. In the credible voltage difference set, each credible voltage difference corresponds to one sampling time point. Each credible voltage difference and a corresponding sampling time point may form a credible data point set.

In embodiments of this application, polynomial regression may be used to perform polynomial fitting. For example, a polynomial may be set as F(t)=atⁿ+btⁿ⁻¹+...+C. Herein, n is a degree of the polynomial, and a, b, c are parameters to be fitted. t is time, and t may be a sampling time point of each frame of data. F(t) is a fitted polynomial, and F(t) represents fitted voltage differences at different time points. F(t) may be a fitted curve with time as a horizontal axis and a fitted voltage difference as a vertical axis. The polynomial curve F(t) may pass through all credible data points in the credible data point set, so that a loss of F(t) is minimized, thereby obtaining a fitted polynomial curve. It should be noted that a quantity of credible data points in the credible data point set needs to be greater than n to obtain the polynomial curve through fitting.

The electronic device may perform filtering processing on the fitted voltage difference corresponding to each frame of data within the specified time period to obtain the processed voltage difference corresponding to each frame of data. After obtaining the fitted polynomial curve, the fitted voltage difference corresponding to each time point may be obtained based on the fitted polynomial curve, to obtain the fitted voltage difference corresponding to each frame of data within the specified time period.

At an inflection point, a smallest value theory exists, that is, if a sampling time point of the cell with the maximum voltage and a sampling time point of the cell with the minimum voltage are not the same, there is a very high probability that a voltage difference calculated based on the voltage of the cell with the maximum voltage and the voltage of the cell with the minimum voltage is greater than a true voltage difference. However, a case of a small probability may occur, that is, the voltage difference calculated based on the voltage of the cell with the maximum voltage and the voltage of the cell with the minimum voltage may be smaller than the true voltage difference. This may result in a small quantity of outliers existing in the credible voltage difference set. To avoid the impact of these outliers, the electronic device may perform filtering processing on the fitted voltage difference corresponding to each frame of data within the specified time period, to obtain the processed voltage difference corresponding to each frame of data. This makes the processed voltage difference corresponding to each frame of data closer to the true voltage difference. For example, a filtering algorithm may be used to perform filtering processing on the fitted voltage difference corresponding to each frame of data within the specified time period, to filter out noise (that is, remove an outlier from the fitted voltage difference) and obtain the processed voltage difference corresponding to each frame of data. For example, the filtering algorithm may be a Butterworth low-pass filtering algorithm. A filter for the filtering algorithm may be a finite impulse response (finite impulse response, FIR) filter. The FIR filter is a type of digital filter and is a convolution process in time domain, allowing filtering to be performed directly in time domain. The filtering algorithm may further convert data in time domain into frequency domain and perform low-pass filtering in frequency domain.

Optionally, step (11) may specifically include the following steps.

(111) The electronic device obtains, based on a correspondence between the voltage difference corresponding to each frame of data and a sampling time point corresponding to each frame of data, a first curve of the voltage difference corresponding to each frame of data within the specified time period varying with time.

(112) The electronic device determines a first curve segment in the first curve in which the voltage difference is greater than a first threshold, determines a lower envelope region in the first curve segment, and determines N smallest voltage differences in the lower envelope region as the credible voltage difference set from the voltage difference corresponding to each frame of data within the specified time period, where N is an integer greater than or equal to 2.

Step (111) and step (112) are a method for determining the credible voltage difference set.

Based on the foregoing smallest value theory, at an inflection point, if a sampling time point of the cell with the maximum voltage and a sampling time point of the cell with the minimum voltage are not the same, there is a very high probability that a voltage difference calculated based on the voltage of the cell with the maximum voltage and the voltage of the cell with the minimum voltage is greater than a true voltage difference. Since the voltage difference at the inflection point is large, the first curve segment with a larger voltage difference may be selected based on the first threshold. The lower envelope region in the first curve segment is determined, and the smallest N voltage differences in the lower envelope region are determined as the credible voltage difference set from the voltage difference corresponding to each frame of data within the specified time period.

Optionally, the first curve does not represent an actual curve, but rather a correspondence between the voltage difference corresponding to each frame of data within the specified time period and a time point.

The lower envelope region in the first curve segment refers to a decreasing trend region and an increasing trend region that are adjacent in the first curve segment. The decreasing trend region is a region in which a magnitude of decrease is greater than a second threshold, and the increasing trend region is a region in which a magnitude of increase is greater than the second threshold. The second threshold may be specified in advance. The lower envelope region includes the decreasing trend region and the increasing trend region that are adjacent.

The first threshold may be specified in advance. The first threshold is greater than a difference between an upper limit value of a voltage fluctuation range of a first plateau region and a lower limit value of the voltage fluctuation range of the first plateau region, the first threshold is greater than a difference between an upper limit value of a voltage fluctuation range of a second plateau region and a lower limit value of the voltage fluctuation range of the second plateau region, and the first threshold is less than an absolute value of a difference between the upper limit value of the voltage fluctuation range of the first plateau region and the lower limit value of the voltage fluctuation range of the second plateau region. The first plateau region and the second plateau region are two adjacent plateau regions in the SOC-OCV curve of the battery. The upper limit value of the voltage fluctuation range of the first plateau region is less than the lower limit value of the voltage fluctuation range of the second plateau region. For example, the first plateau region may be the large plateau region 1 in the SOC-OCV curve shown in FIG. 1, and the second plateau region may be the large plateau region 2 in the SOC-OCV curve shown in FIG. 1. For example, in the first plateau region, a voltage of a cell fluctuates within 3.295 to 3.305 V, and in the second plateau region, a voltage of a cell fluctuates within 3.345 to 3.355 V. In this case, the first threshold may be set to a value greater than 10 mV and less than 40 mV. For example, the first threshold may be set to 25 mV.

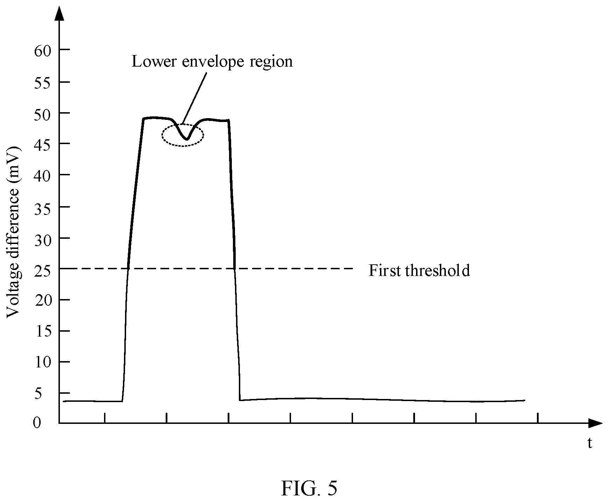

Refer to FIG. 5. FIG. 5 is a schematic diagram of a first curve of a voltage difference varying with time according to an embodiment of this application. In the first curve shown in FIG. 5 of the voltage difference corresponding to each frame of data within the specified time period varying with time, a horizontal axis is time, and a vertical axis is a voltage difference. The first curve varies with time, and the voltage difference varies within a range of 0 to 50 mV. It should be noted that the first curve is obtained based on a plurality of frames of data. The first curve is formed by a plurality of discrete data points. The time on the horizontal axis of the first curve is a discrete value, that is, a sampling time point of each frame of data. The voltage difference on the vertical axis of the first curve is also a discrete value. A bold curve in FIG. 5 is a first curve segment in which the voltage difference is greater than the first threshold in the first curve. In FIG. 5, for example, the first threshold is 25 mV. It can be seen from the first curve segment that there is a lower envelope region in the first curve segment, and in the lower envelope region, the voltage difference is relatively small. The smallest N voltage differences in all discrete data points in the lower envelope region may be determined as the credible voltage difference set. N may be greater than the degree of the polynomial used for fitting. N is greater than the degree n of the polynomial used for fitting.

403: The electronic device determines the battery SOC interval based on a correspondence between the processed voltage difference corresponding to each frame of data and the battery SOC value in each frame of data, where a processed voltage difference corresponding to the battery SOC interval is greater than a specified threshold.

In embodiments of this application, each frame of data includes a battery SOC value, and each frame of data corresponds to a processed voltage difference. The correspondence between the processed voltage difference corresponding to each frame of data and the battery SOC value in each frame of data may be established based on the processed voltage difference corresponding to each frame of data and the battery SOC value in each frame of data. The correspondence may include a relationship pair set. The relationship pair set includes a plurality of relationship pairs, and each relationship pair includes a processed voltage difference and a corresponding battery SOC value. The relationship pair set may be stored in a memory (for example, a non-volatile memory) of the electronic device. From the relationship pair set, a target relationship pair set in which the processed voltage difference is greater than the specified threshold may be determined. An interval of SOC values in the target relationship pair set is determined, that is, the battery SOC interval.

Optionally, step 403 may specifically include the following steps.

(21) The electronic device obtains, based on the correspondence between the processed voltage difference corresponding to each frame of data and the battery SOC value in each frame of data, a second curve of the processed voltage difference within the specified time period varying with the battery SOC value.

(22) The electronic device determines a second curve segment in the second curve in which the processed voltage difference is greater than the specified threshold, and determines a battery SOC interval corresponding to the second curve segment.

In embodiments of this application, there is a one-to-one correspondence between the processed voltage difference corresponding to each frame of data and the battery SOC value in each frame of data. The second curve of the processed voltage differences within the specified time period varying with the battery SOC value may be obtained based on the correspondence.

Optionally, the second curve is not limited to being represented in a form of an actual curve, and may alternatively be a correspondence or a functional relationship between the processed voltage difference and the battery SOC value within the specified time period.

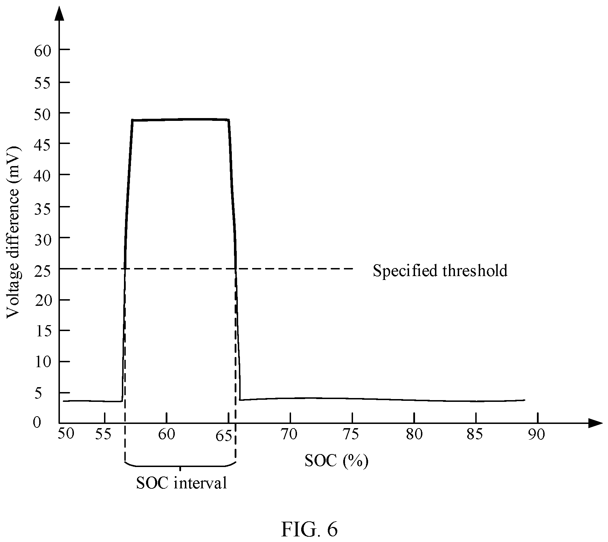

Refer to FIG. 6. FIG. 6 is a schematic diagram of a second curve of a voltage difference varying with a battery SOC value according to an embodiment of this application. In the second curve shown in FIG. 6 of the processed voltage difference within the specified time period varying with the battery SOC value, a horizontal axis is a battery SOC value, and a vertical axis is a voltage difference. The second curve varies with the battery SOC value, and the voltage difference varies within a range of 0 to 50 mV. It should be noted that the second curve is obtained based on a plurality of frames of data. The second curve is formed by a plurality of discrete data points. The time on the horizontal axis of the second curve is a discrete value, that is, an SOC value of each frame of data. The voltage difference on the vertical axis of the second curve is also a discrete value. A bold curve in FIG. 6 is a second curve segment in which the voltage difference is greater than a specified threshold in the second curve. In FIG. 6, for example, the specified threshold is 25 mV. The SOC interval corresponding to the voltage difference greater than the specified threshold may be seen from the second curve segment.

Optionally, step (21) may specifically include the following steps.

(211) The electronic device determines, based on the correspondence between the processed voltage difference corresponding to each frame of data and the battery SOC value in each frame of data, a smallest value in at least two processed voltage differences corresponding to a same battery SOC value as the processed voltage difference corresponding to the same battery SOC value.

(212) The electronic device obtains, based on a processed voltage difference corresponding to each different battery SOC value, the second curve of the processed voltage difference within the specified time period varying with the battery SOC value.

In embodiments of this application, since there are a large quantity of frames of data within the specified time period, two or more frames of data may have a same battery SOC value (for example, in a discharging operating condition, when the vehicle is stopped at a traffic light, the battery SOC value barely changes, and therefore consecutive frames of data have a same battery SOC value). During generation of the second curve, for a same battery SOC value, only one voltage difference needs to be taken. In embodiments of this application, the smallest value in at least two processed voltage differences corresponding to the same battery SOC value is determined as the processed voltage difference corresponding to the same battery SOC value. Selecting the smallest voltage difference, based on the foregoing smallest value theory, increases the probability that the processed voltage difference corresponding to the same battery SOC value is closer to the true voltage difference. In this way, accuracy of the second curve of the voltage differences varying with the battery SOC values is improved, which in turn enhances accuracy of a calculation result for the SOC deviation of the battery.

Optionally, the specified threshold is greater than a difference between the upper limit value of the voltage fluctuation range of the first plateau region and the lower limit value of the voltage fluctuation range of the first plateau region, the specified threshold is greater than a difference between the upper limit value of the voltage fluctuation range of the second plateau region and the lower limit value of the voltage fluctuation range of the second plateau region, the specified threshold is less than an absolute value of a difference between the upper limit value of the voltage fluctuation range of the first plateau region and the lower limit value of the voltage fluctuation range of the second plateau region. The first plateau region and the second plateau region are two adjacent plateau regions in the SOC-OCV curve of the battery, and the upper limit value of the voltage fluctuation range of the first plateau region is less than the lower limit value of the voltage fluctuation range of the second plateau region. For example, the first plateau region may be the large plateau region 1 in the SOC-OCV curve shown in FIG. 1, and the second plateau region may be the large plateau region 2 in the SOC-OCV curve shown in FIG. 1. For example, in the first plateau region, a voltage of a cell fluctuates within 3.295 to 3.305 V, and in the second plateau region, a voltage of a cell fluctuates within 3.345 to 3.355 V. In this case, the specified threshold may be set to a value greater than 10 mV and less than 40 mV. For example, the specified threshold may be set to 25 mV.

The specified threshold and the first threshold may be set to a same value, or may be set to different values.

Optionally, the SOC-OCV curve of the battery includes a small plateau region, a first large plateau region, and a second large plateau region, and an SOC value of the first large plateau region is greater than an SOC value of the small plateau region and less than an SOC value of the second large plateau region; and the first plateau region is one of the first large plateau region and the second large plateau region, and the second plateau region is the other of the first large plateau region and the second large plateau region. For example, the first large plateau region may be the large plateau region 1 in the SOC-OCV curve shown in FIG. 1, and the second large plateau region may be the large plateau region 2 in the SOC-OCV curve shown in FIG. 1.

404: The electronic device determines a difference between the upper limit value of the battery SOC interval and the lower limit value of the battery SOC interval as the SOC deviation of the battery, where the SOC deviation of the battery is used to measure consistency of the battery.

For specific implementation of step 401 and step 404, refer to the foregoing step 201 and step 203. Details are not described herein again.

Optionally, after step 404 is performed, the following step (31) may further be performed.

(31) The electronic device uploads the SOC deviation of the battery to a cloud server.

In embodiments of this application, the SOC deviation calculated by the electronic device may be uploaded in real time to the cloud server that analyzes consistency of the battery, and serve as a data foundation for subsequent development, such as studying a trend of cell consistency changes, to determine whether the battery has excessively rapid consistency changes or other possible problems in the cell. Another feature (for example, a minimum cell proportion and a maximum cell proportion during a time period) may also be uploaded simultaneously to serve as criteria, thereby enhancing credibility of consistency of the battery.

The electronic device may be a cloud server that calculates the SOC deviation of the battery. The cloud server that calculates the SOC deviation of the battery may upload the calculated SOC deviation to the cloud server that analyzes the consistency of the battery. The cloud server that calculates the SOC deviation of the battery and the cloud server that analyzes the consistency of the battery may be different servers.

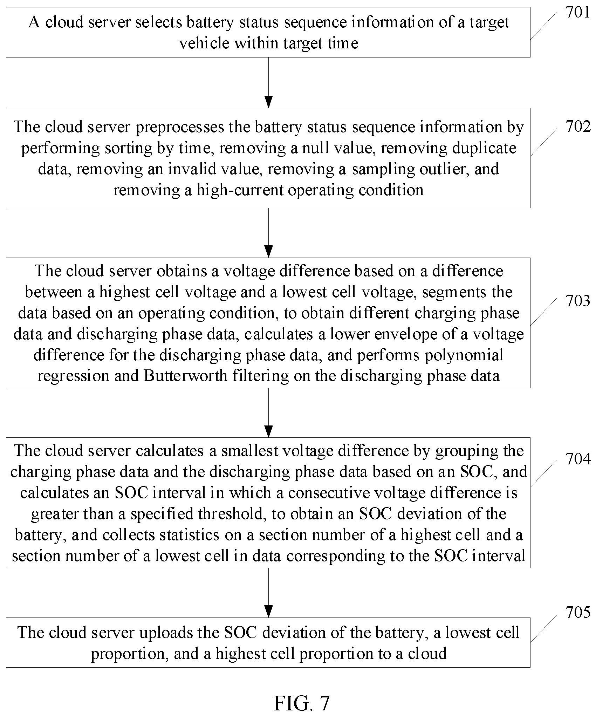

Refer to FIG. 7. FIG. 7 is a specific schematic flowchart of a method for determining consistency of a battery according to an embodiment of this application. As shown in FIG. 7, the method for determining consistency of a battery includes the following steps.

701: A cloud server selects battery status sequence information of a target vehicle within target time.

There may be a plurality of pieces of battery status sequence information, which may correspond to the foregoing original data frames.

The battery status sequence information may include: vehicle status data, a maximum voltage and a minimum voltage of a cell, a current, a temperature, a battery SOC value, a quantity of maximum cells and a quantity of minimum cells, and the like. The vehicle may mark the data with a sampling time point and upload the data to the cloud server for subsequent processing.

702: The cloud server preprocesses the battery status sequence information by performing sorting by time, removing a null value, removing duplicate data, removing an invalid value, removing an outlier, and removing a high-current operating condition.

The data uploaded by the vehicle may be preprocessed every 24 hours. The preprocessing includes sorting by time, removing a null value, removing duplicate data, removing an invalid value, removing a sampling outlier, and deleting data that is not applicable to an operating condition of an algorithm, and the like.

The preprocessed data is input into the algorithm. In the algorithm, filtering and analysis are mainly performed on values, for example, a battery SOC value, a maximum cell voltage *V*ₘₐₓ, a minimum cell voltage *V*ₘᵢₙ, a maximum cell section number Nmax, and a minimum cell section number Nmin.

703: The cloud server obtains a voltage difference based on a difference between the maximum cell voltage and the minimum cell voltage, segments the data based on an operating condition, to obtain different charging phase data and discharging phase data, calculates a lower envelope of a voltage difference for the discharging phase data, and performs polynomial regression and Butterworth filtering on the discharging phase data.

Specifically, a difference between the maximum cell voltage *V*ₘₐₓ and the minimum cell voltage *V*ₘᵢₙ is calculated, that is, *V*_{diff} =*V*ₘₐₓ -*V*ₘᵢₙ. The obtained *V*_{diff} represents a voltage difference exhibited between a cell with a maximum state of charge and a cell with a minimum state of charge.

Because a voltage is unstable in a discharging phase, and a sampled cell voltage may fluctuate, filtering needs to be performed on the voltage difference *V*_{diff} of the cell to remove a minor sampling error and different voltage transient responses caused by a large current. First, the lower envelope of the voltage difference is calculated. Then, polynomial regression and interpolation are performed on a value of the lower envelope to obtain *V*ₑₙᵥ (that is, the foregoing fitted voltage difference). Then, Butterworth low-pass filtering is performed on *V*ₑₙᵥ to remove noise, to obtain a smoothed voltage difference *V*ₑₙᵥ. In this case, a voltage difference when the battery SOC value is between 50% and 90% may be used to determine consistency (There is a very high voltage difference in voltages when the SOC is above 90%, and an influence from a low inflection point is exerted when the SOC is below 50%. Therefore, data from an SOC interval between 50% and 90% is selected).

704: The cloud server calculates a smallest voltage difference by grouping the charging phase data and the discharging phase data based on the SOC, calculates an SOC interval in which a consecutive voltage difference is greater than a specified threshold, to obtain an SOC deviation of the battery, and collects statistics on a maximum cell section number and a minimum cell section number in data corresponding to the SOC interval.

In embodiments of this application, a grouping operation using integer SOCs (for example, the SOCs may be divided into 50%, 51%, 52%, ..., 90%, that is, 41 groups in total) as indexes is performed on data of SOCs of an entire battery pack between 50% and 90%, and a grouping function is to calculate the smallest value, thereby transforming a variable from time (a data frame quantity) to an SOC, to obtain a smallest voltage difference corresponding to each integer SOC value.

The specified threshold may be determined from FIG. 1. As seen in FIG. 1, when the lithium iron phosphate battery is in the two different large plateau regions, the voltage difference is above 25 mV. Therefore, the threshold for the voltage difference is set to 25 mV. If the cell with the maximum state of charge and the cell with the minimum state of charge are simultaneously within a same plateau region, *V*_{diff} calculated from *V*ₘₐₓ-*V*ₘᵢₙ is very small. As the vehicle discharges or charges, the cell with the maximum state of charge and the cell with the minimum state of charge successively pass through the inflection point 2 between the large plateau region 1 and the large plateau region 2. *SOC*₁ when the cell with the maximum voltage passes through the inflection point and *SOC*₂ when the cell with the minimum voltage passes through the inflection point are recorded, and | *SOC*₂ - *SOC*₁ | is a consistency deviation of the cell.

705: The cloud server uploads the SOC deviation of the battery, a minimum cell proportion, and a maximum cell proportion to a cloud.

The calculated SOC deviation may be uploaded in real time to the cloud server to serve as a data foundation for subsequent development, such as studying a trend of cell consistency changes, to determine whether the battery has excessively rapid consistency changes or other possible problems in the cell. In addition, another feature (for example, a minimum cell proportion and a maximum cell proportion during a time period) may also be uploaded simultaneously to serve as criteria, thereby enhancing credibility of consistency.

The minimum cell proportion refers to a proportion of each cell being a cell with the minimum voltage in the data corresponding to the SOC interval. The maximum cell proportion refers to a proportion of each cell being a cell with the maximum voltage in the data corresponding to the SOC interval.

A technical problem that embodiments of this application may solve is as follows: A method for calculating a state of charge (SOC) deviation of a cell of a battery is overly reliant on specific charging phase data. When the specific data is missing, or only exists recently, a conventional algorithm fails or cannot obtain a real-time state of charge deviation of the cell. When data quality is poor, for example, a synchronization rate is insufficient, in a conventional solution, data in an alternating current charging phase is used, and data in a discharging phase cannot be used.

The algorithm in embodiments of this application is applicable to different vehicle operating conditions. This algorithm uses data including the alternating current charging phase to calculate the state of charge deviation of the battery, and can also use data including the discharging phase to calculate the state of charge deviation of the battery, thereby obtaining the state of charge deviation of the battery more timely.

Embodiments of this application can determine the state of charge deviation of the battery, and determine whether there is another consistency problem (for example, an internal resistance anomaly and a liquid leakage) based on the state of charge deviation of the battery. Embodiments of this application may continuously track a consistency status of the battery by calculating the state of charge deviation of the battery of the vehicle on the cloud server, thereby providing a foundation for a trend algorithm.

The solutions of embodiments of this application are described above from a perspective of an execution process on a method side. It may be understood that, to implement the foregoing functions, the electronic device includes a corresponding hardware structure and/or a software module for executing each function. A person skilled in the art should be readily aware that this application can be implemented in hardware or a combination of hardware and computer software in combination with the units and algorithm steps described in embodiments provided herein. Whether a specific function is performed by hardware or by computer software driving hardware depends on the specific application and design constraints of the technical solution. A person skilled in the art can implement the described functions through different methods for each specific application, but such implementation should not be considered to be beyond the scope of this application.

Embodiments of this application may divide the electronic device into functional units based on the foregoing method examples. For example, individual functional units may be divided corresponding to respective functions, or two or more functions may be integrated into one processing unit. The integrated unit may be implemented in a form of hardware or in a form of a software functional unit. It should be noted that the division of units in embodiments of this application is illustrative, and is merely a logical functional division. In actual implementation, another division manner may alternatively be used.

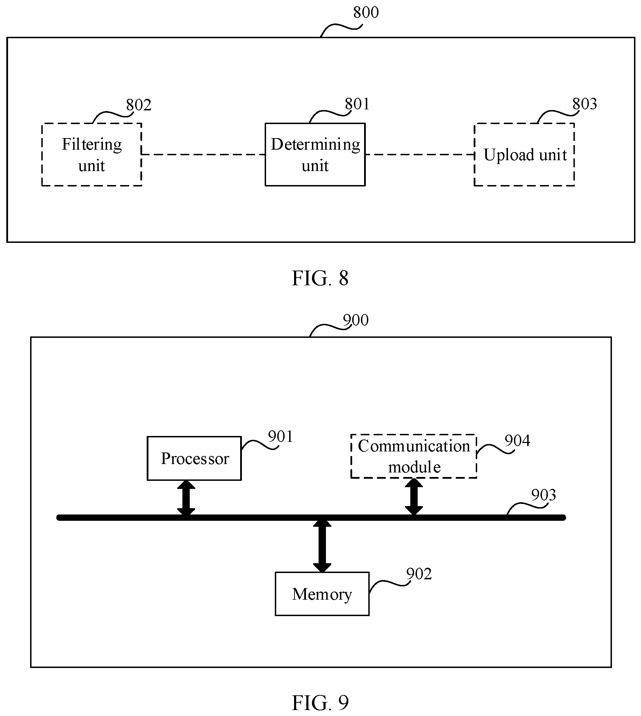

Refer to FIG. 8. FIG. 8 is a schematic diagram of a structure of an apparatus for determining consistency of a battery according to an embodiment of this application. The battery includes at least two cells. The apparatus 800 for determining consistency of a battery may include a determining unit 801.

The determining unit 801 is configured to determine a voltage difference corresponding to each frame of data, where the voltage difference is a difference between a maximum cell voltage and a minimum cell voltage in each frame of data.

The determining unit 801 is further configured to determining a battery SOC interval based on a correspondence between the voltage difference corresponding to each frame of data and the battery SOC value in each frame of data, where a voltage difference corresponding to the battery SOC interval is greater than a specified threshold.

The determining unit 801 is further configured to determine a difference between an upper limit value of the battery SOC interval and a lower limit value of the battery SOC interval, to obtain an SOC deviation of the battery, where the SOC deviation of the battery is used to measure consistency of the battery.

Optionally, each frame of data is any preprocessed frame of data of the battery within a specified time period.

Optionally, the specified time period includes at least one of a discharging period, an alternating current charging period, or a direct current charging period.

Optionally, the preprocessing includes at least one of: sorting by time, removing a null value, removing duplicate data, removing an invalid value, removing a sampling outlier, or removing data that does not meet an operating condition of an algorithm.

Optionally, the apparatus 800 for determining consistency of a battery may further include a filtering unit 802.

The filtering unit 802 is configured to perform filtering processing on the voltage difference corresponding to each frame of data to obtain a processed voltage difference corresponding to each frame of data.

That the determining unit 801 is further configured to determine a battery SOC interval based on a correspondence between the voltage difference corresponding to each frame of data and the battery SOC value in each frame of data, where a voltage difference corresponding to the battery SOC interval is greater than the specified threshold includes: determining the battery SOC interval based on a correspondence between the processed voltage difference corresponding to each frame of data and the battery SOC value in each frame of data, where the processed voltage difference corresponding to the battery SOC interval is greater than the specified threshold.

Optionally, that the filtering unit 802 is configured to perform filtering processing on the voltage difference corresponding to each frame of data to obtain processed voltage difference corresponding to each frame of data includes: determining a credible voltage difference set from the voltage difference corresponding to each frame of data within the specified time period; performing polynomial fitting based on the credible voltage difference set to obtain a fitted voltage difference corresponding to each frame of data within the specified time period; and performing filtering processing on the fitted voltage difference corresponding to each frame of data within the specified time period to obtain the processed voltage difference corresponding to each frame of data.

Optionally, that the filtering unit 802 determines a credible voltage difference set from the voltage difference corresponding to each frame of data within the specified time period includes: obtaining, based on a correspondence between the voltage difference corresponding to each frame of data and a sampling time point corresponding to each frame of data, a first curve of the voltage difference corresponding to each frame of data within the specified time period varying with time; and determining a first curve segment in the first curve in which the voltage difference is greater than a first threshold, determining a lower envelope region in the first curve segment, and determining N smallest voltage differences in the lower envelope region as the credible voltage difference set from the voltage difference corresponding to each frame of data within the set time period, where N is an integer greater than or equal to 2.

Optionally, that the determining unit 801 determines a battery SOC interval based on a correspondence between the processed voltage difference corresponding to each frame of data and the battery SOC value in each frame of data includes: obtaining, based on the correspondence between the processed voltage difference corresponding to each frame of data and the battery SOC value in each frame of data, a second curve of the processed voltage difference within the specified time period varying with the battery SOC value; and determining a second curve segment in the second curve in which the processed voltage difference is greater than the specified threshold, and determining a battery SOC interval corresponding to the second curve segment.

Optionally, that the determining unit 801 obtains, based on the correspondence between the processed voltage difference corresponding to each frame of data and the battery SOC value in each frame of data, a second curve of the processed voltage difference within the specified time period varying with the battery SOC value includes: determining, based on the correspondence between the processed voltage difference corresponding to each frame of data and the battery SOC value in each frame of data, a smallest value in at least two processed voltage differences corresponding to a same battery SOC value as the processed voltage difference corresponding to the same battery SOC value; and obtaining, based on a processed voltage difference corresponding to each different battery SOC value, the second curve of the processed voltage difference within the specified time period varying with the battery SOC value.

Optionally, the apparatus 800 for determining consistency of a battery may further include an upload unit 803.

The upload unit 803 is configured to upload the SOC deviation of the battery to a cloud server.

Optionally, the specified threshold is greater than a difference between an upper limit value of a voltage fluctuation range of a first plateau region and a lower limit value of the voltage fluctuation range of the first plateau region, the specified threshold is greater than a difference between an upper limit value of a voltage fluctuation range of a second plateau region and a lower limit value of the voltage fluctuation range of the second plateau region, the specified threshold is less than an absolute value of a difference between the upper limit value of the voltage fluctuation range of the first plateau region and the lower limit value of the voltage fluctuation range of the second plateau region, and the first plateau region and the second plateau region are two adjacent plateau regions in an SOC-OCV curve of the battery.

Optionally, the SOC-OCV curve of the battery includes a small plateau region, a first large plateau region, and a second large plateau region, and an SOC value of the first large plateau region is greater than an SOC value of the small plateau region and less than an SOC value of the second large plateau region; and the first plateau region is one of the first large plateau region and the second large plateau region, and the second plateau region is the other of the first large plateau region and the second large plateau region.

In embodiments of this application, the determining unit 801 and the filtering unit 802 may be processors in an electronic device. The upload unit 803 may be a communication module in the electronic device.

In embodiments of this application, the battery SOC interval is determined based on the correspondence between the voltage difference corresponding to each frame of data and the battery SOC value in each frame of data, and the difference between the upper limit value of the battery SOC interval and the lower limit value of the battery SOC interval is determined as the SOC deviation of the battery. In a process of determining the SOC deviation of the battery, only the battery SOC value needs to be used, and there is no need to calculate an SOC value of each cell. This can reduce a computational load for determining the SOC deviation, thereby quickly determining consistency of the battery.

Refer to FIG. 9. FIG. 9 is a schematic diagram of a structure of an electronic device according to an embodiment of this application. As shown in FIG. 9, the electronic device 900 includes a processor 901 and a memory 902. The processor 901 and the memory 902 may be connected to each other via a communication bus 903. The communication bus 903 may be a peripheral component interconnect (peripheral component interconnect, PCI for short) bus, an extended industry standard architecture (extended industry standard architecture, EISA for short) bus, a controller area network (controller area network, CAN) bus, or the like. The communication bus 903 may be classified into an address bus, a data bus, a control bus, and the like. For ease of representation, only one bold line is used in FIG. 9 to represent the bus, but this does not indicate that there is only one bus or one type of bus. The memory 902 is configured to store a computer program. The computer program includes program instructions. The processor 901 is configured to invoke the program instructions, where the program includes some or all of the steps used to perform the method included in FIG. 2 to FIG. 7.

The processor 901 may be a general-purpose central processing unit (central processing unit, CPU), a microprocessor, an application-specific integrated circuit (application-specific integrated circuit, ASIC), or one or more integrated circuits configured to control execution of the foregoing solution program.

The memory 902 may be a read-only memory (read-only memory, ROM) or another type of static storage device capable of storing static information and instructions, a random access memory (random access memory, RAM) or another type of dynamic storage device capable of storing information and instructions, or may be an electrically erasable programmable read-only memory (electrically erasable programmable read-only memory, EEPROM), a compact disc read-only memory (compact disc read-only memory, CD-ROM) or another optical disc memory, a compact disc memory (including a compact disc, a laser disc, an optical disc, a digital versatile disc, a Blu-ray disc, and the like), a magnetic disk storage medium or another magnetic storage device, or any other medium that can be used to carry or store desired program code in a form of instructions or data structures and that can be accessed by a computer, but is not limited thereto. The memory may exist independently, and is connected to the processor via a bus. The memory may alternatively be integrated with the processor.

The electronic device 900 may further include a communication module 904. An SOC deviation of a battery may be uploaded to a cloud server through the communication module 904. An original data frame uploaded by a vehicle may also be received through the communication module 904.

In embodiments of this application, the battery SOC interval is determined based on the correspondence between the voltage difference corresponding to each frame of data and the battery SOC value in each frame of data, and the difference between the upper limit value of the battery SOC interval and the lower limit value of the battery SOC interval is determined as the SOC deviation of the battery. In a process of determining the SOC deviation of the battery, only the battery SOC value needs to be used, and there is no need to calculate an SOC value of each cell. This can reduce a computational load for determining the SOC deviation, thereby quickly determining consistency of the battery.

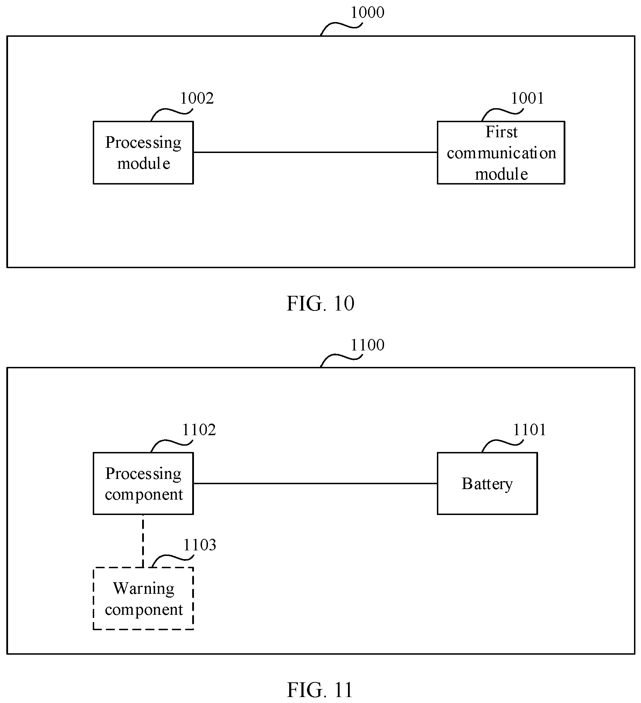

Refer to FIG. 10. FIG. 10 is a schematic diagram of a structure of a server according to an embodiment of this application. As shown in FIG. 10, the server 1000 includes a first communication module 1001 and a processing module 1002. The first communication module 1001 is configured to communicate with an electric energy device in which a battery is located to receive each frame of data. The processing module 1002 is configured to perform some or all of the steps of any method for determining consistency of a battery described in the foregoing method embodiments.

The processing module 1002 may be a general-purpose central processing unit (central processing unit, CPU), a microprocessor, an application-specific integrated circuit (application-specific integrated circuit, ASIC), or one or more integrated circuits configured to control execution of the method for determining consistency of a battery.

Optionally, when the SOC deviation is greater than a preset warning threshold, the processing module 1002 is further configured to send a warning signal to the electric energy device through the first communication module 1001.

Refer to FIG. 11. FIG. 11 is a schematic diagram of a structure of an electric energy device according to an embodiment of this application. As shown in FIG. 11, the electric energy device 1100 includes a battery 1101 and a processing component 1102. The processing component 1102 is configured to perform some or all of the steps of any method for determining consistency of a battery described in the foregoing method embodiments based on each frame of data of the battery 1101.

The processing component 1102 may be a general-purpose central processing unit (central processing unit, CPU), a microprocessor, an application-specific integrated circuit (application-specific integrated circuit, ASIC), or one or more integrated circuits configured to control execution of the method for determining consistency of a battery.

Optionally, the electric energy device includes a warning component 1103, and the processing component 1102 is further configured to: when the SOC deviation is greater than a preset warning threshold, trigger the warning component 1103 to issue warning information and/or transmit warning prompt information to a third-party device.

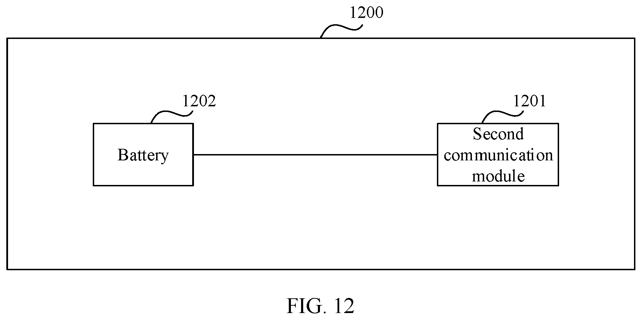

Refer to FIG. 12. FIG. 12 is a schematic diagram of a structure of another electric energy device according to an embodiment of this application. As shown in FIG. 12, the electric energy device 1200 includes a battery 1202 and a second communication module 1201. The second communication module 1201 is configured to transmit each frame of data of the battery 1202 to the server 1000, to enable the server 1000 to perform some or all of the steps of any method for determining consistency of a battery described in the foregoing method embodiments based on each frame of data.

An embodiment of this application further provides a computer-readable storage medium, where the computer-readable storage medium stores a computer program for electronic data exchange. The computer program enables a computer to perform some or all of the steps of any method for determining consistency of a battery described in the foregoing method embodiments.

It should be noted that, the foregoing method embodiments are described as a combination of a series of actions for simplicity. However, a person skilled in the art should understand that this application is not limited by the described order of actions, for according to this application, some steps may be performed in a different order or concurrently. Furthermore, a person skilled in the art should also understand that embodiments described in the specification are all preferred embodiments, and the involved actions and modules are not necessarily essential to this application.

In the foregoing embodiments, descriptions of embodiments have respective focuses. For a part that is not detailed in an embodiment, refer to related descriptions in other embodiments.

In the several embodiments provided in this application, it should be understood that the disclosed apparatus may be implemented in another manner. For example, the apparatus embodiments described above are merely examples. For example, division of the units is merely division of logical functions. In actual implementation, there may be another division manner. For example, a plurality of units or components may be combined or integrated into another system, or some features may be ignored or not executed. In addition, the mutual coupling or direct coupling or a communication connection shown or discussed may be indirect coupling or a communication connection implemented through some interfaces, apparatuses, or units, may be electrical, or may be of another form.

The units described as separate components may or may not be physically separate. The components displayed as units may or may not be physical units, that is, may be located in one place, or may be distributed across a plurality of network units. Some or all of the units may be selected based on actual needs to achieve the objectives of embodiments.

In addition, the functional units in embodiments of this application may be integrated into one processing unit, or each unit may exist separately as a physical entity, or two or more units may be integrated into one unit. The foregoing integrated unit may be implemented in hardware or in a form of a software program module.

If the integrated unit is implemented in the form of the software program module and is sold or used as an independent product, the unit may be stored in a computer-readable memory. Based on such understanding, the technical solution of this application, in essence or the part contributing to the conventional technology, or all or a part of the technical solution, may be embodied in the form of a software product. This computer software product is stored in a memory and includes instructions for enabling a computer device (which may be a personal computer, a server, a network device, or the like) to perform all or some of the steps of the methods described in the embodiments of this application. The foregoing memory includes any medium that can store program code, for example, a USB flash drive, a read-only memory (read-only memory, ROM), a random access memory (random access memory, RAM), a removable hard disk, a magnetic disk, or an optical disc.

A person of ordinary skill in the art may understand that some or all of the steps in the methods of the foregoing embodiments may be accomplished by a program instructing related hardware. The program may be stored in a computer-readable memory. The memory may include: a flash drive, a read-only memory, a random access memory, a magnetic disk, an optical disc, and the like.

Embodiments of this application are described in detail above. The principles and implementations of this application are described in this specification by using specific examples. The descriptions of the foregoing embodiments are merely used for helping understand the method and core ideas of this application. In addition, a person of ordinary skill in the art may change a specific implementation and an application scope based on the idea of this application. In summary, content of this specification should not be construed as a limitation on this application.

## Claims

1. A method for determining consistency of a battery, wherein the battery comprises at least two cells, and the method comprises:
determining a voltage difference corresponding to each frame of data, wherein the voltage difference is a difference between a maximum cell voltage and a minimum cell voltage in each frame of data (201);
determining a battery SOC interval based on a correspondence between the voltage difference corresponding to each frame of data and a battery state of charge SOC value in each frame of data, wherein a voltage difference corresponding to the battery SOC interval is greater than a specified threshold (202); and
determining a difference between an upper limit value of the battery SOC interval and a lower limit value of the battery SOC interval as an SOC deviation of the battery, wherein the SOC deviation of the battery is used to measure consistency of the battery (203).

2. The method according to claim 1, wherein each frame of data is any preprocessed frame of data of the battery within a specified time period.

3. The method according to claim 2, wherein the specified time period comprises at least one of a discharging period, an alternating current charging period, or a direct current charging period.

4. The method according to claim 2 or 3, wherein the preprocessing comprises at least one of: sorting by time, removing a null value, removing duplicate data, removing an invalid value, removing a sampling outlier, or removing data that does not meet an operating condition of an algorithm.

5. The method according to any one of claims 2-4, wherein after the determining a voltage difference corresponding to each frame of data, the method further comprises:
performing filtering processing on the voltage difference corresponding to each frame of data to obtain a processed voltage difference corresponding to each frame of data (402); and
the determining a battery SOC interval based on a correspondence between the voltage difference corresponding to each frame of data and a battery SOC value in each frame of data, wherein a voltage difference corresponding to the battery SOC interval is greater than a specified threshold comprises:
determining the battery SOC interval based on a correspondence between the processed voltage difference corresponding to each frame of data and the battery SOC value in each frame of data, wherein a processed voltage difference corresponding to the battery SOC interval is greater than the specified threshold (403).

6. The method according to claim 5, wherein the performing filtering processing on the voltage difference corresponding to each frame of data to obtain a processed voltage difference corresponding to each frame of data comprises:
determining a credible voltage difference set from the voltage difference corresponding to each frame of data within the specified time period;
performing polynomial fitting based on the credible voltage difference set to obtain a fitted voltage difference corresponding to each frame of data within the specified time period; and
performing filtering processing on the fitted voltage difference corresponding to each frame of data within the specified time period to obtain the processed voltage difference corresponding to each frame of data.

7. The method according to claim 6, wherein the determining a credible voltage difference set from the voltage difference corresponding to each frame of data within the specified time period comprises:
obtaining, based on a correspondence between the voltage difference corresponding to each frame of data and a sampling time point corresponding to each frame of data, a first curve of the voltage difference corresponding to each frame of data within the specified time period varying with time; and
determining a first curve segment in the first curve in which the voltage difference is greater than a first threshold, determining a lower envelope region in the first curve segment, and determining N smallest voltage differences in the lower envelope region as the credible voltage difference set from the voltage difference corresponding to each frame of data within the specified time period, wherein N is an integer greater than or equal to 2.

8. The method according to any one of claims 5-7, wherein the determining the battery SOC interval based on a correspondence between the processed voltage difference corresponding to each frame of data and the battery SOC value in each frame of data comprises:
obtaining, based on the correspondence between the processed voltage difference corresponding to each frame of data and the battery SOC value in each frame of data, a second curve of the processed voltage difference within the specified time period varying with the battery SOC value; and
determining a second curve segment in the second curve in which the processed voltage difference is greater than the specified threshold, and determining a battery SOC interval corresponding to the second curve segment.

9. The method according to claim 8, wherein the obtaining, based on the correspondence between the processed voltage difference corresponding to each frame of data and the battery SOC value in each frame of data, a second curve of the processed voltage difference within the specified time period varying with the battery SOC value comprises:
determining, based on the correspondence between the processed voltage difference corresponding to each frame of data and the battery SOC value in each frame of data, a smallest value in at least two processed voltage differences corresponding to a same battery SOC value as the processed voltage difference corresponding to the same battery SOC value; and
obtaining, based on a processed voltage difference corresponding to each different battery SOC value, the second curve of the processed voltage difference within the specified time period varying with the battery SOC value.

10. The method according to any one of claims 1-9, wherein after the obtaining the SOC deviation of the battery, the method further comprises:
uploading the SOC deviation of the battery to a cloud server.

11. The method according to any one of claims 1-10, wherein the specified threshold is greater than a difference between an upper limit value of a voltage fluctuation range of a first plateau region and a lower limit value of the voltage fluctuation range of the first plateau region, the specified threshold is greater than a difference between an upper limit value of a voltage fluctuation range of a second plateau region and a lower limit value of the voltage fluctuation range of the second plateau region, the specified threshold is less than an absolute value of a difference between the upper limit value of the voltage fluctuation range of the first plateau region and the lower limit value of the voltage fluctuation range of the second plateau region, and the first plateau region and the second plateau region are two adjacent plateau regions in an SOC-OCV curve of the battery.

12. The method according to claim 11, wherein the SOC-OCV curve of the battery comprises a small plateau region, a first large plateau region, and a second large plateau region, and an SOC value of the first large plateau region is greater than an SOC value of the small plateau region and less than an SOC value of the second large plateau region; and the first plateau region is one of the first large plateau region and the second large plateau region, and the second plateau region is the other of the first large plateau region and the second large plateau region.

13. A server (1000), wherein the server (1000) comprises a first communication module (1001) and a processing module (1002), the first communication module (1001) is configured to communicate with an electric energy device (1200) in which a battery (1202) is located to receive each frame of data, and the processing module (1002) is configured to perform the method according to any one of claims 1-12.

14. The server according to claim 13, wherein when the SOC deviation is greater than a preset warning threshold, the processing module (1002) is further configured to send a warning signal to the electric energy device (1100) through the first communication module (1001).

15. An electric energy device (1200), wherein the electric energy device (1200) comprises a battery (1202) and a second communication module (1201), the second communication module (1201) is configured to transmit each frame of data of the battery (1202) to a server (1000), to enable the server (1000) to perform the method according to any one of claims 1-12 based on each frame of data.

16. An electric energy device (1100), wherein the electric energy device (1100) comprises a battery (1101) and a processing component (1102), and the processing component (1102) is configured to perform the method according to any one of claims 1-12 based on each frame of data of the battery (1101).

17. The device according to claim 16, wherein the electric energy device comprises a warning component (1103), and the processing component (1102) is further configured to: when the SOC deviation is greater than a preset warning threshold, trigger the warning component (1103) to issue warning information and/or transmit warning prompt information to a third-party device.

18. An electronic device (900), comprising a processor (901) and a memory (902), wherein the memory (902) is configured to store a computer program, the computer program comprises program instructions, and the processor (901) is configured to invoke the program instructions to perform the method according to any one of claims 1-12.

19. A computer-readable storage medium, wherein the computer-readable storage medium stores a computer program, the computer program comprises program instructions, and the program instructions, when executed by a processor, enable the processor to perform the method according to any one of claims 1-12.

20. A computer program product, wherein the computer program product comprises a computer program, and the computer program is operable to enable a computer to perform the method according to any one of claims 1-12.

21. A processor (901), wherein the processor is configured to invoke program instructions to perform the method according to any one of claims 1-12.
